Europäisches Patentamt

**European Patent Office**

**Office européen des brevets**

(19)

(11) Publication number: **0 031 706**
**B1**

## (12) EUROPEAN PATENT SPECIFICATION

(45) Date of publication of patent specification: **07.11.84**

(51) Int. Cl.³: **G 01 R 31/28, G 11 C 29/00**

(21) Application number: **80304670.5**

(22) Date of filing: **22.12.80**

(54) Apparatus and method for testing semiconductor memory devices.

<table>
<tr><td>

(30) Priority: **27.12.79 JPU 182455/79**

(43) Date of publication of application:
**08.07.81 Bulletin 81/27**

(45) Publication of the grant of the patent:
**07.11.84 Bulletin 84/45**

(84) Designated Contracting States:
**DE FR GB**

(56) References cited:
**DE-A-2 921 243**
**DE-B-2 408 990**

</td><td>

(73) Proprietor: **FUJITSU LIMITED**
**1015, Kamikodanaka Nakahara-ku**
**Kawasaki-shi Kanagawa 211 (JP)**

(72) Inventor: **Shigeki, Nozaki**
**473-4-203 Hisasue**
**Takatsu-ku, Kawasaki-shi Kanagawa 213 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

</td></tr>
</table>

Courier Press, Leamington Spa, England.

# Description

The present invention generally relates to apparatus and methods for testing semiconductor memory devices, and more particularly to a semiconductor memory device testing method and apparatus which enables testing of a semiconductor memory device to be performed in a swap mode, that is, in a mode in which X and Y addresses of the semiconductor memory device are interchanged.

In semiconductor memory devices such as a ROM (Read Only Memory) or a RAM (Random Access Memory), storage cells are arranged in an X-Y matrix form, and a desired storage cell is selected by specifying the X-address and Y-address. However, when the capacity of a semiconductor memory device of the above type is increased as in an LSI (Large Scale Integrated) circuit, the probability of hardware errors introduced upon manufacturing in the storage cells of one or more bits, becomes high.

For example DE—B2—2 408 990 discloses a program controlled system for testing a storage unit, for example an integrated circuit storage unit. An address held in an address unit is used to access the storage unit under test and reference data is entered into the accessed address. Stored data is then read out from the accessed address and a comparator compares the read out data and the reference data to detect errors. The address held in the address unit, and the reference data, are provided by an instruction read out from a microprogram control unit, in each cycle time of which an address is entered into the address unit.

Conventionally, a method was proposed in which redundancy bits are provided to relieve the defective bits having hardware errors, to decrease the percentage of the defective bits within the memory device. Another method proposed is a method in which error correcting codes are used to compensate for the defective bits within the system. Hence, defects in some bits of the memory device do not make the whole memory device (chip) defective. However there is a problem. The problem is that, the memory device which is ready for use is tested before it is built into a system, but when a defective bit exists in the memory device, the margin characteristic of the memory device cannot be determined, and the testing of the memory device is interrupted.

In order to overcome the above described problems, still another method was considered, but not published, which stores the address of the defective bit into another memory (fail or fault memory) device, so that when access is made to the defective bit, this access is prohibited by the output signal supplied from the above fault memory device, and masking of the memory device is performed under operational testing. That is, if a defective bit exists at a certain address of a RAM device, for example, information to indicate that the bit at this certain address is defective, is written-in to a fault memory device at the same address location as that of the above certain address. Hence, upon operational testing of this RAM device, access is made to the fault memory device together with the RAM device, and, according to the information stored in the fault memory device, prohibits the operational testing of the defective bit within the RAM device. Accordingly, the RAM device can be tested as if no defective bits existed even when defective bits exist in that RAM device, and, the RAM device tested can be treated as being fully operational, when there are no other defective parts within the RAM device.

Operational testing is also performed under a swap mode in which the $X$ and $Y$ addresses of the memory device are interchanged, other than in a normal mode in which access to the bits of the memory device are made in the order the address is specified. This testing under swap mode is sometimes necessary, since some of the characteristics of a memory device depend on the address patterns. For example, there often are cases in which the defective bits are concentrated at certain columns (Y-side) or rows (X-side), within the memory device. In this case, the whereabouts of the defects can be easily found, when the $X$ and $Y$ addresses are interchanged and scanning is performed along the column or row having concentrated defective bits therein. Furthermore, there are many types of testing systems, mainly galloping system, walking system, and the like and address swapping is required to perform these types of tests.

Generally, when the addresses of the bits in the memory device are specified in a 12-bit signal (A0~A11), the lower six bits (A0~A5) of the above 12-bit signal generated by an address pattern generator is selected as the X-address, and the higher six bits (A6~A11) as the Y-address. Therefore, when a defective bit exists at the X-address (A0~A5) "010000" and Y-address (A6~A11) "001000" in a normal mode, for example, the address of the defective bit in the swap mode in this case becomes "010000" for the XX-address (A6~A11) and "001000" for the YY-address (A0~A5) since the address pattern generator maintains the same output as that in normal mode, where XX and YY respectively designate the $X$ and $Y$ addresses in the swap mode. However, this address changeover is only performed for the memory device (usually a RAM device) and not for the fault memory device. Accordingly, the address upon normal mode is always set in the fault memory device, that is, "010000" for the X-address (A0~A5) and "001000" for the Y-address (A6~A11), in the case of normal mode. But upon swap mode, when XX-address is "010000" and YY-address is "001000", the address in the fault memory device is set as being "001000" for the X-address and "010000" for the Y-address. This result does not correspond to the original address of the defective bit in the memory device, and hence the defective bit cannot be masked.

Therefore, in this unpublished method, for example, the information stored in the fault memory device upon normal mode is erased and new information is stored into the fault memory device in swap mode, to enable the masking of the defective bits. However, this operation of storing information into the fault memory device twice, complicates the testing method, and suffers disadvantages in that the required operation time is increased.

Accordingly, the present invention aims to provide a novel and useful semiconductor memory device testing method and apparatus in which the above described problems have been overcome.

The present invention aims to provide a semiconductor memory device testing method and apparatus in which the output of an address pattern generator is supplied to a fault memory device through an address swapping part.

According to one aspect of the present invention there is provided apparatus for testing a semiconductor memory device, the apparatus comprising:

an address pattern generator for generating an address pattern which successively specifies the X-Y addresses of all memory cells of a semiconductor memory device which is to be tested;

a comparator which is arranged, in a first operational phase, to compare data read-out from each of the memory cells of said semiconductor memory device with an expected value to detect the existence or non-existence of a hardware error in each of the memory cells of the semiconductor memory device;

characterised in that the apparatus further comprises a fault memory device which is arranged, in said first operational phase, to store information concerning the existence or non-existence of a hardware error in each of the memory cells of said semiconductor memory device in each of the memory cells of said fault memory device corresponding to those of said semiconductor memory device; and

an address changeover means which is arranged to access said semiconductor memory device and said fault memory device with said address pattern supplied by said address pattern generator in a normal mode, and to access said semiconductor memory device and said fault memory device with an address pattern supplied by said address pattern generator in which predetermined addresses are interchanged, in a swap mode-

said semiconductor memory device and said fault memory device being arranged to receive common addresses in the normal mode and in the swap mode, and said fault memory device being arranged to emit, in a second operational phase a signal which inhibits the operation of the comparator upon receipt of an address at which the respective memory cell of said fault memory device contains information indicating the existence of hardware error in the corresponding memory cell of said semiconductor memory device.

According to another aspect of the present invention there is provided a method of testing a semiconductor memory device by means of apparatus as set forth above, comprising the steps of:

(a) generating by means of an address pattern generator an address pattern which successively specifies the X-Y addresses of all memory cells of said semiconductor memory device;

(b) feeding in a first and in a second operational phase said addresses to said semiconductor memory device;

(c) comparing in said first phase, by means of a comparator, data read-out from each of the memory cells of said semiconductor memory device with an expected value to detect the existence or non-existence of a hardware error in each of the memory cells of said semiconductor memory device; characterised by:—

(d) storing in a fault memory device information concerning the existence or non-existence of hardware error in each of the memory cells of said semiconductor memory device in each of the memory cells of said fault memory device corresponding to those of said semi-conductor memory device;

(e) said step (b) comprising feeding said addresses both to said semiconductor memory device and to said fault memory device via address changeover means which accesses said semi-conductor memory device and said fault memory device with said address pattern supplied by said address pattern generator in a normal mode, and which accesses said semiconductor memory device and said fault memory device with an address pattern supplied by said address pattern generator in which predetermined addresses are interchanged, in a swap mode; and

(f) inhibiting in said second phase the operation of said comparator upon receipt by said fault memory device of an address at which the respective memory cell of said fault memory device contains information indicating the existence of a hardware error in the corresponding memory cell of said semiconductor memory device.

For a better understanding of the invention and to show how the same may be carried into effect, reference will be made by way of example, to the accompanying diagrammatic drawings, in which:

Fig. 1 is a simplified block diagram showing an embodiment of a semiconductor memory device testing apparatus according to the present invention;

Figures 2A and 2B are diagrams showing respective defective bits, for explaining the relationship between the address locations in a memory which is to be tested and a fault memory in a normal mode operation:

Figures 3A and 3B are diagrams showing respective defective bits, for explaining the relationship between the address locations in the memory which is to be tested and fault memory, in a swap mode operation;

Figure 4 is a block diagram showing essential parts of an address system of Figure 1; and

Figure 5 is a detailed diagram showing the construction of a pin selector of Figure 4.

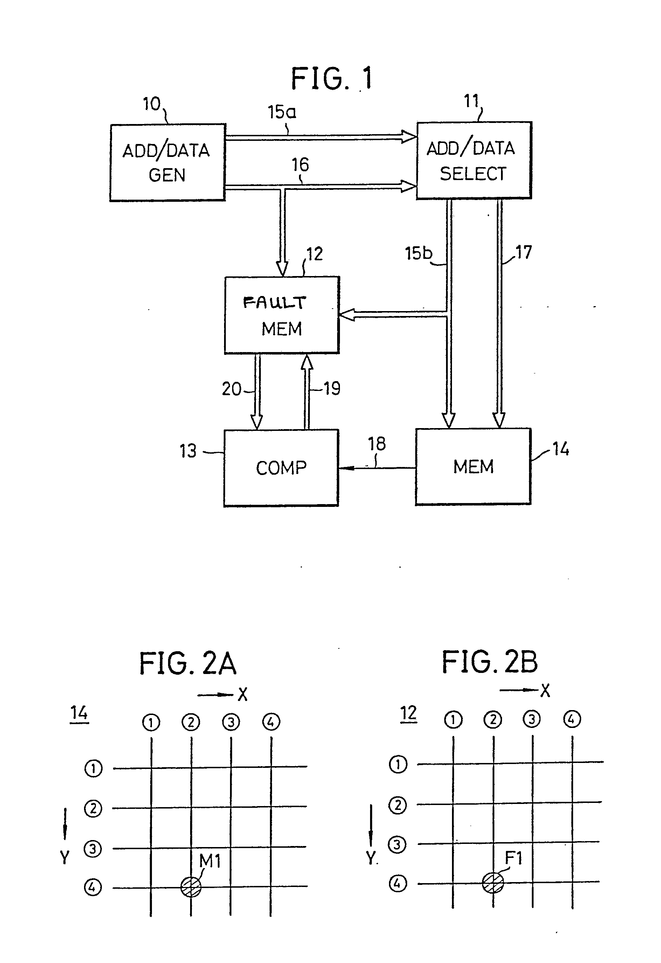

In Figure 1, an address pattern/data generator 10 also generates a test data pattern. Upon operation in any mode, an address pattern specified by an address bus 15a which is generated by the address pattern/data generator 10 is applied to an address changeover means (address/data selector 11), and on the other hand, data specified by a data bus 16 is supplied to both the address/data selector 11 and a fail or fault memory device 12. The above data specified by the data bus 16 is also supplied to a semiconductor memory device 14 which is to be tested, through the address/data selector 11 by a data bus 17. An address specified by an address bus 15b is supplied to the fault memory device 12, from the address/data selector 11.

When data specified by a data bus 18 is read-out from the memory device 14, this read-out data is compared with an expected value at a comparator 13. Hence, when all the bits in the memory device 14 are normal, the data specified by the data bus 18 and the expected value are equal. However, when a defective bit exists, the defective bit is detected by the inequality of the data specified by the data bus 18 and the expected value. An output data specified by a data bus 19 which is supplied from the comparator 13, indicates the normal or defective state of all the bits within the memory device 14, and this information is stored into the fault memory device 12. This corresponds to a first operational phase. As described above, the address of the fault memory device 12 is specified by the address specified by the address bus 15b which is supplied from the address/data selector 11. A signal 20 supplied from the fault memory device 12 controls the comparing operation performed by the comparator 13, and prohibits the comparison to be performed for the defective bits, that is, enables the defective bits to be masked, in a second operational phase.

Upon normal mode operation, for example, the address pattern specified by the address bus 15a which is applied to the address/data selector 11, and the address specified by the address bus 15b which is supplied from the address/data selector 11, are the same address. Accordingly, the same address is supplied to both the fault memory device 12 and the memory device 14. Hence when a defective bit M1 exists at an address X=2 and Y=4 of the memory device as shown in Fig. 2A, for example, the information concerning the defective bit M1 is written-in to a bit F1 of the fault memory device 12 at the address X=2 and Y=4, as shown in Fig. 2B. Therefore, when the above defective bit M1 of the memory device 14 is selected, the bit F1 of the fault memory device is simultaneously selected. Thus, the content of the bit F1 is supplied to the comparator 13 as the signal 20 (indicating that the bit is defective), and prohibits the comparison to be performed for the bit M1.

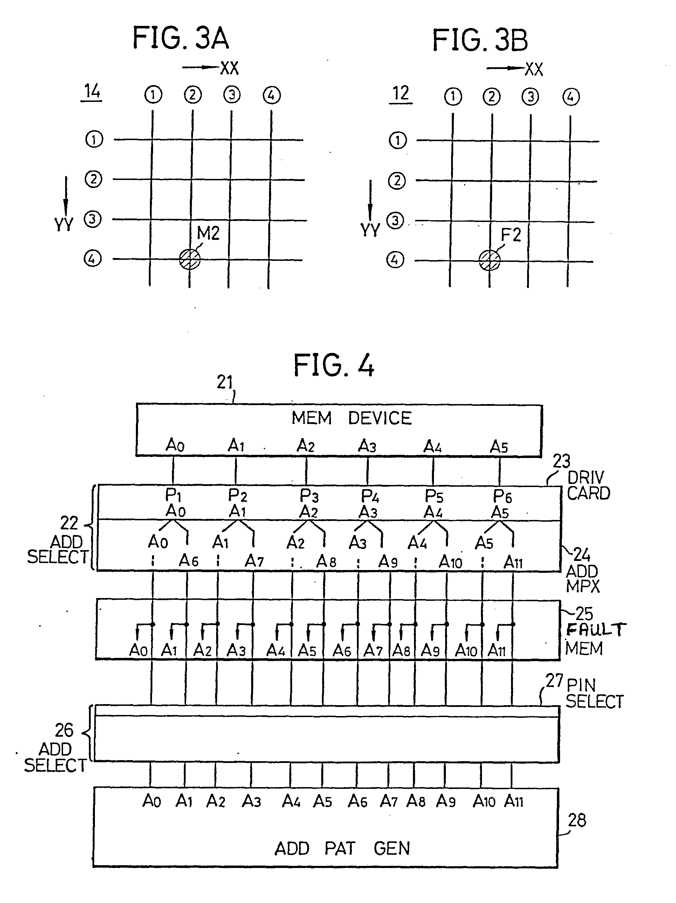

On the other hand, in a swap mode operation, the address pattern specified by the address bus 15a and the address specified by the address bus 15b are not equal. That is, the X and Y addresses of the address specified by the address bus 15b comprise the interchanged X and Y addresses of the address pattern specified by the address bus 15a. However, this interchanged address, namely, the address specified by the address bus 15b is supplied to both the fault memory device 12 and the memory device 14, as in the normal mode. In this case, difference from the normal mode lies in the fact that the address supplied to both the fault memory device 12 and the memory device 14, is the address which is interchanged at the address/data selector 11. This can be shown by the diagrams of Figs. 3A and 3B. Fig. 3A shows a bit M2 of a memory device in the swap mode at an address XX=2 and YY=4. Fig. 3B shows a bit F2 of a fault memory device in the swap mode, corresponding to the bit M2 of the above memory device, at an address XX=2 and YY=4. The rest of the operation is identical to that upon normal mode operation, and accordingly, when a defective bit exists, the defective bit can be correctly masked.

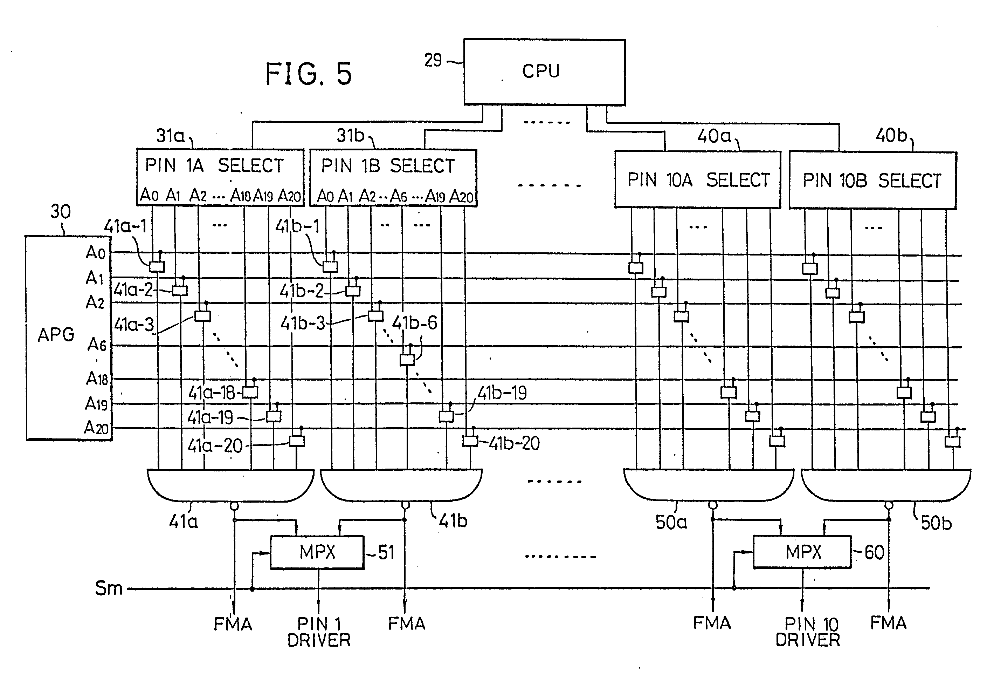

Fig. 4 is a block diagram showing the essential parts of the address system of Fig. 1, in which the comparator 13 is not shown, to simplify the diagram. Each of address selectors 22 and 26 comprises a pin selector 27, drive card 23, an address multiplexer 24, and the like. In Fig. 4, P1 through P6 designate drive pins. A0 through A11 designate address bits. However, the contents of the address bits designated by the same symbol in the different stages are not necessarily the same. An address pattern generator is designated by the numeral 28. Address changover means (address selectors) 22 and 26 comprise pin selector means arranged to receive pin selection information signals from a central processing unit (not shown in Figure 4—see Figure 5), address multiplexor means arranged to multiplex output signals of the pin select means, and drive card means connected to receive the multiplexed output signals of the address multiplexor means and a control signal, the drive card means being arranged to supply output signals to both the fault memory device and to the memory device to be tested. In Figure 4, the fault memory device and the memory device to be tested are indicated by reference numerals 25 and 24 respectively.

The essential part of the above address selectors 22 and 26, is the pin selector 27, and a more detailed diagram showing the construction of the pin selector is illustrated in Fig. 5. The example shown in Fig. 5 is a case in which twenty-one address bits, A0 through A20, are used. In Fig. 5, 30 is an address pattern generator (APG).

In Fig. 5, the pin selector comprises pin selecting circuit pairs 31a and 31b through 40a and 40b, a matrix part having NAND-gates 41a-1 through 41a-20, 41b-1 through 41b-20, - - -, and NAND-gates 41a through 50b which mix the output signal from the above matrix part, Multiplexers 51 through 60 which multiplex the output fault memory addresses FMA supplied by NAND-gate pairs 41a and 41b through 50a and 50b, correspond to the address multiplexer 24 of Fig. 4. Accordingly, the multiplexers 51 through 60 are controlled by a multiplexing signal Sm, and apply their output signal to driver pins 1 through 10 of the driver card 23. When the content of the address bits A0 and A6 of the address pattern generator 28 of Fig. 4 are to be used for the driver pin P1, for example, the address bit A0 of the pin selecting circuit 31a is set at a high level, and the other address bits of that pin selecting circuit are set at low levels. Similarly, the address bit A6 of the pin selecting circuit 31b is set at a higher level, and the other address bits of that pin selecting circuit are set at low levels.

Accordingly, the output levels of the NAND-gates excluding the NAND-gates 41a-1 and 41b-6 are forcibly set low, and the output signals of the NAND-gates 41a-1 and 41b-6 respectively become of reversed logic as those of the address bits A0 and A6 of the address pattern generator 28. However, the NAND-gates at the output stage again reverse the logic of the above output signals, and therefore, the output fault memory addresses FMA of the NAND-gates 41a and 41b become of the same phase as those of the outputs in the address bits A0 and A6 of the address pattern generator 28.

On the other hand, when address swapping is to be performed for the address bits A0 and A6, the address bit A6 of the pin selecting circuit 31a is set at a high level, and the other address bits of that pin selecting circuit are all set at low levels. Similarly, by setting the level of the address bit A0 of the pin selecting circuit 31b high, and setting the level of the other address bits of that pin selecting circuit low, the relationship between the address bits A0 and A6 becomes that of a swap mode. The above explanation is applicable to all the other address bits; thus, the output fault memory address FMA is used for accessing to both the memory device which is to be tested and the fault memory device.

As described above, the testing of a semiconductor memory device is simplified according to the illustrated semiconductor memory device testing apparatus and method since, after the defective bits are written-in to the fault memory device, the masking operation is not affected by the address swapping performed in the memory device which is to be tested.

**Claims**

1. Apparatus for testing a semiconductor memory device, the apparatus comprising:

an address pattern generator (10) for generating an address pattern which successively specifies the X-Y addresses of all memory cells of a semiconductor memory device (14) which is to be tested;

a comparator (13) which is arranged, in a first operational phase, to compare data read-out from each of the memory cells of said semiconductor memory device (14) with an expected value to detect the existence or non-existence of a hardware error in each of the memory cells of the semiconductor memory device (14);

characterised in that the apparatus further comprises a fault memory device (12) which is arranged, in said first operational phase, to store information concerning the existence or non-existence of a hardware error in each of the memory cells of said semiconductor memory device (14) in each of the memory cells of said fault memory device corresponding to those of said semiconductor memory device (14); and

an address changeover means (11) which is arranged to access said semiconductor memory device (14) and said fault memory device (12) with said address pattern supplied by said address pattern generator (10) in a normal mode, and to access said semiconductor memory device (14) and said fault memory device (12) with an address pattern supplied by said address pattern generator (10) in which predetermined addresses are interchanged, in a swap mode;

said semiconductor memory device (14) and said fault memory device (12) being arranged to receive common addresses in the normal mode and in the swap mode; and said fault memory device (12) being arranged to emit in a second operational phase a signal which inhibits the operation of the comparator (13) upon receipt of an address at which the respective memory cell of said fault memory device (12) contains information indicating the existence of a hardware error in the corresponding memory cell of said semiconductor memory device (14).

2. Apparatus according to claim 1 wherein said address pattern generator (10) is arranged also to supply data to said semiconductor memory device (14), together with said address pattern, via said address changeover means (11).

3. Apparatus according to claim 1 or 2, wherein said address changeover means (11) comprises pin select means (27) arranged to receive a pin selection information signal supplied from a central processing unit (29), address multiplexer means (24) arranged to multiplex output signals of said pin select means (27), and drive card means (23) connected to receive the multiplexed output signals of said address multiplexer means (24) and a control signal, said drive card means (23) being arranged to supply output signals to both said fault memory device (12) and said semiconductor memory device (14) which is to be tested, to specify specific X-Y addresses of memory cells therein.

4. Apparatus according to claim 3, wherein said pin select means (27) comprises a plurality of pin selecting circuit pairs (31a, 31b...) which are connected respectively to receive said pin selection information signal from said central processing unit (29), a plurality of matrix part pairs (41a-1, 41b-1...) which respectively receive the outputs of said pin selecting circuit pairs (31a, 31b...), each of said matrix part pairs (41a-1, 41b-1...) comprising a plurality of NAND-gates, and a plurality of NAND-gate pairs (41a, 41b...) which respectively mix the output signals from said matrix part pairs (41a-1, 41b-1...), and supply their output signals to both said semi-conductor memory device (14) and said fault memory device (12).

5. A method of testing a semiconductor memory device (14) by means of an apparatus according to any one of claims 1 to 4, comprising the steps of:

(a) generating by means of an address pattern generator (10) an address pattern which successively specifies the X-Y addresses of all memory cells of said semiconductor memory device (14);

(b) feeding in a first and in a second operational phase said addresses to said semi-conductor memory device (14);

(c) comparing in said first phase, by means of a comparator (13), data read-out from each of the memory cells of said semiconductor memory device (14) with an expected value to detect the existence or non-existence of a hardware error in each of the memory cells of said semiconductor memory device (14); characterised by:—

(d) storing in a fault memory device (12) information concerning the existence or non-existence of hardware error in each of the memory cells of said semiconductor memory device in each of the memory cells of said fault memory device corresponding to those of said semiconductor memory device (14);

(e) said step (b) comprising feeding said addresses both to said semiconductor memory device (14) and to said fault memory device (12) via address changeover means (11) which accesses said semiconductor memory device (14) and said fault memory device (12) with said address pattern supplied by said address pattern generator in a normal mode, and which accesses said semiconductor memory device (14) and said fault memory device (12) with an address pattern supplied by said address pattern generator (10) in which predetermined addresses are interchanged, in a swap mode; and

(f) inhibiting in said second phase the operation of said comparator (13) upon receipt by said fault memory device (12) of an address at which the respective memory cell of said fault memory device (12) contains information indicating the existence of a hardware error in the corresponding memory cell of said semiconductor memory device (14).

**Revendications**

1. Appareil de contrôle d'une mémoire à semi-conducteurs, appareil comportant:

un générateur d'adresses (10) destiné à produire une configuration qui spécifie successivement les adresses X-Y de toutes les cellules d'une mémoire à semi-conducteurs (14) qui doit être contrôlée;

un comparateur (13° qui est agencé, dans une première phase de fonctionnement, pour comparer des données lues dans chacune des cellules de ladite mémoire à semi-conducteurs (14) avec une valeur prévue pour détecter l'existence ou la on-existence d'une erreur matérielle dans chacune des cellules de la mémoire à semi-conducteurs (14);

caractérisé en ce que l'appareil comporte en ce que l'appareil comporte en outre une mémoire de faute (12) qui est agencée dans ladite première phase de fonctionnement, pour mémoriser des informations concernant l'existence ou la non-existence d'une erreur matérielle dans chacune des cellules de ladite mémoire à semi-conducteurs (14), dans chacune des cellules de ladite mémoire de faute correspondant à celles de ladite mémoire à semi-conducteurs (14); et

un dispositif de permutation d'adresses (11) qui est agence pour accéder à ladite mémoire à semi-conducteurs (14) et à ladite mémoire de faute avec ladite configuration d'adresses fournie par ledit générateur d'adresses (10) dans un mode normal et pour accéder à ladite mémoire à semi-conducteurs (14) et à ladite mémoire de faute (12) avec une configuration d'adresses fournie par ledit générateur d'adresses (10) dans laquelle les adresses prédéterminées sont inververties dans un mode d'échange;

ladite mémoire à semi-conducteurs (14) et ladite mémoire de faute (12) étant agencées pour recevoir des adresses communes dans le mode normal et dans le mode d'échange, et ladite mémoire de faute (12) étant agencée pour émettre dans une seconde phase de fonctionnement, un signal qui inhibe fonctionnement du comparateur (13) à la réception d'une adresse à laquelle les cellules respectives de ladite mémoire de faute (12) contiennent des informations indiquant l'existence d'une erreur matérielle dans la cellule correspondante de ladite mémoire à semi-conducteurs (14).

2. Appareil selon la revendication 1, dans lequel ledit génératuer d'adresses (10) est également agencé pour fournir des données à ladite mémoire à semi-conducteurs (14) avec ladite configuration d'adresses, par l'intermédiaire dudit dispositif de permutation d'adresses (11).

3. Appareil selon la revendication 1 ou 2 dans lequel ledit dispositif de permutation d'adresses (11) comporte un sélecteur de broches (27) agencé pour recevoir un signal d'informations de sélection de broches fournie par une unité centrale de traitement (29), un multiplexeur d'adresses (24) agencé pour multiplexer des signaux de sortie dudit sélecteur de broches (27) et une carte d'attaque (23) con-nectée pour recevoir les signaux de sortie multiplexés dudit multiplexeur d'adresses (24) et un signal de commande, la carte d'attaque (23) étant agencée pour fournir des signaux de sortie à la fois à ladite mémoire de faute (12) et à ladite mémoire à semi-conducteurs (14) qui doit être contrôlée pour spécifier des adresses X-Y spécifiques de cellules qu'elle contient.

4. Appareil selon la revendication 3, dans lequel ledit sélecteur de broches (27) comporte plusieurs paires de circuits de sélection de broches (31a, 31b...) qui sont connectés respectivement pour recevoir ledit signal d'informations de broches provenant de ladite unité centrale de traitement (29), plusieurs paires de parties de matrices (41a-1, 41b-1...) qui reçoivent respectivement les sorties desdites paires de circuits de sélection de broches 31a—31b...), chacune desdites paires de parties de matrice, (41a-1, 41b-1...) comprenant plusieurs portes NON-ET, et plusieurs paires de portes NON-ET (41a—41b) qui mélangent respectivement les signaux de sortie desdites paires de parties de matrice (41a-1, 41b-1...) et qui fournissent leurs signaux de sortie à ladite mémoire á semi-conducteurs (14) et à ladite mémoire de faute (12).

5. Procédé de contrôle d'une mémoire à semi-conducteur (14) au moyen d'un appareil selon l'une quelconque des revendications 1 à 5, consistant essentiellement:

(a) à produire au moyen d'un générateur d'adresses (10) une configuration d'adresses qui spécifie successivement les adresses X-Y de toutes les cellules de ladite mémoire à semi-conducteurs (14);

(b) à fournir dans une première et une seconde phases de fonctionnement lesdites adresses à ladite mémoire à semi-conducteurs (14);

(c) à comparer dans ladite première phase, au moyen d'un comparateur (13) des données lues dans chacune des cellules de ladite mémoire à semi-conducteurs (14) avec une valeur prévue pour détecter l'existence ou la non existence d'une erreur matérielle dans chacune des cellules de ladite mémoire à semi-conducteurs (14) caractérisé en ce qu'il consiste également:

(d) à mémoriser dans une mémoire de faute (12) des informations concernant l'existence ou la non-existence d'une erruer matérielle dans chacune des cellules de ladite mémoire à semi-conducteurs, dans chacune des cellules de ladite mémoire de faute correspondant à celles de ladite mémoire à semi-conducteurs (14)

(e) la phase (b) consistant à fournir lesdites adresses à la fois à ladite mémoire à semi-conducteurs (14) et à ladite mémoire de faute (12) par un dispositif de permutation d'adresses (11) qui accède à ladite mémoire à semi-conducteurs (14) et à ladite mémoire de faute (12), avec ladite configuration d'adresses fournie par ledit générateur d'adresses dans un mode normal et qui accède à ladite mémoire à semi-conducteurs (14) et à ladite mémoire de faute (12) avec une configuration d'adresses fournie par ledit générateur d'adresses (10) dans laquelle des adresses prédéterminées sont interverties dans un mode d'échange; et

(f) à inhiber dans ladite seconde phase le fonctionnement dudit comparateur (13) à la réception par ladite mémoire de faute (12) d'une adresse à laquelle la cellule respective de ladite mémoire de faute (12) contient une information indiquant l'existence d'une erreur matérielle dans la cellule correspondante de ladite mémoire à semi-conducteurs (14).

**Patentansprüche**

1. Vorrichtung zum Testen einer Halbleiterspeichervorrichtung, mit:

einem Adreßmustergenerator (10) zur Erzeugung eines Adressenmusters, welches sukzessive die X-Y-Adressen aller Speicherzellen einer Halbleiterspeichervorrichtung (14), die zu prüfen ist, erzeugt,

einem Komparator (13), welcher, in einer ersten Betriebsphase, so angeordnet ist, daß er von jeder der Speicherzellen der genannten Halbleiterspeichervorrichtung (14) ausgelesene Daten mit einem erwarteten Wert vergleicht, um die Existenz oder Nichtexistenz eines Hardwarefehlers in jeder der Speicherzellen der Halbleiterspeichervorrichtung (14) festzustellen, dadurch gekennzeichnet,

daß die Vorrichtung ferner eine Fehlerspeichereinrichtung (12) umfaßt, welche in der genannten ersten Betriebsphase, so angeordnet ist, daß sie Information speichert, welche die Existenz oder Nichtexistenz eines Hardwarefehlers in jeder der Speicherzellen der genannten Halbleiterspeichvorrichtung (14) in jeweils den Speicherzellen der genannten Fehlerspeichereinrichtung speichert, welche denjenigen der genannten Halbleiterspeichervorrichtung (14) entsprechen.

und eine Adressenwechseleinrichtung (11), welche so angeordnet ist, daß sie zu der Halbleiterspeichervorrichtung (14) und der genannten Fehlerspeichereinrichtung (12) mit dem genannten Adressenmuster Zugriff hat, welches von dem genannten ersten Adressenmustergenerator (10) in einem normalen Betriebsmodus erzeugt wird, und daß sie zu der genannten Halbleiterspeichervorrichtung (14) under der genannten Fehlerspeichereinrichtung (12) mit einem von dem genannten Adressenmustergenerator (10) gelieferten Adressenmuster Zugriff hat, in welchem, in einem Swap-Modus, vorbestimmte Adressen ausgewechselt sind,

und daß die genannte Halbleiterspeichervorrichtung (14) und die genannte Fehlerspeichereinrichtung (12) so angeordnet sind, daß sie gemeinsame Adressen in dem normalen Betriebsmodus und in dem Swap-Modus empfangen, und die genannte Fehlerspeichereinrichtung (12) so angeordnet ist, daß sie in einer zweiten Betriebsphase ein Signal erzeugt, welches den Betrieb des Komparators (13) bei Empfang einer Adresse sperrt, bei welcher die entsprechende Speicherzelle der genannten Fehlerspeichereinrichtung (12) Information enthält, die die Existenz eines Hardwarefehlers in der entsprechenden Speicherzelle der Halbleiterspeichervorrichtung (14) anzeigt.

2. Vorrichtung nach Anspruch 1, bei welcher der genannte Adressenmustergenerator (10) so angeordnet ist, daß er, über die genannte Adressenwechseleinrichtung (11), auch zu der genannten Halbleiterspeichervorrichtung (14) Daten liefert, zusammen mit den genannten Adressenmustern.

3. Vorrichtung nach Anspruch 1 oder 2, bei welcher die genannte Adressenwechseleinrichtung (11) eine Stiftauswahleinrichtung (27) umfaßt, welche so angeordnet ist, daß sie ein Informationssignal bezüglich der Stiftauswahl empfängt, welches von einer zentralen Prozessoreinheit (29) geliefert wird, und Adressenmultiplexereinrichtungen (24), welche so angeordnet sind, daß sie Ausgangssignale der genannten Stiftauswahleinrichtungen (27) mutliplexen, und Treiberkarteneinrichtungen (33), welche angeschlossen sind, um die Multiplex-Ausgangssignale der genannten Adressen-multiplexereinrichtung (24) und ein Steuersignal zu empfangen, wobei die genannte Treiberkarteneinrichtung (23) so angeordnet ist, daß sie Ausgangssignale zu sowohl der gentannten Fehlerspeichereinrichtung (12) als auch zu der genannten Halbleiterspeichervorrichtung (14), welche geprüft werden soll, liefert, um bestimmte X-Y-Adressen der darin enthaltenen Speicherzellen zu spezifizieren.

4. Vorrichtung nach Anspruch 3, bei welcher die genannten Stiftauswahleinrichtungen (27) eine Vielzahl von Stiftauswahlschaltungspaaren (31a, 31b . . .) umfassen, welche jeweils

so angeschlossen sind, daß sie das genannte Stiftauswahl Informationssignal von der genannten zentralen Prozessoreinheit (29) empfangen, und eine Vielzahl von Matrixteilpaaren (41a-1, 41b-1 . . .), welche jeweils die Ausgangzeichen der genannten Pinauswahlschaltungspaare (31a, 31b . . .) empfangen, wobei, jedes der Matrixteilpaare (41a-1, 41b-1 . . .) eine Anzahl von NAND-Gliedern umfaßt, und eine Vielzahl von NAND-Gliederpaaren (41a, 41b . . .), welche jeweils die Ausgangssignale von den genannten Matrixteilpaaren (41a-1, 41b-1 . . .) mischen und ihre Ausgangssignale sowohl der genannten Halbleiterspeichervorrichtung (14) als auch der genannten Fehlerspeichereinrichtung (12) zuführen.

5. Verfahren zum Prüfen einer Halbleiterspeichervorrichtung (14) mittels einer Vorrichtung nach einem der Ansprüche 1 bis 4, mit den folgenden Schritten:

(a) Erzeugung, mittels eines Adressenmustergenerators (10), eines Adressenmusters, welches sukzessive die X-Y-Adressen aller Speicherzellen der genannten Halbleiterspeichervorrichtung (14) spezifiziert,

(b) Zuführung der genannten Adressen zu der Halbleiterspeichervorrichtung (14) in einer ersten und einer zweiten Betriebsphase.

(c) Vergleichen, in der genannten ersten Phase, mittels eines Komparators (13), der von jeder der Speicherzellen der genannten Halbleiterspeichervorrichtung (14) ausgelesenen Daten mit einem erwarteten Wert, um die Existenz oder Nichtexistenz eines Hardwarefehlers in jeder der Speicherzellen der genannten Halbleiterspeichervorrichtung (14) zu bestimmen, gekennzeichnet durch:

(d) Speichern, in einer Fehlerspeichereinrichtung (12), von Information, welche die Existenz oder Nicht existenz eines Hardwarefehlers in jeder der Speicherzellen der genannten Halbleiterspeichervorrichtung betrifft, in jeder der Speicherzellen der genannten Fehlerspeichereinrichtung (12), welche denjenigen der genannten Halbleiterspeichervorrichtung (14) entsprechen,

(e) wobei der genannte Schritt (b) die Zuführung der genannten Adressen sowohl zu der genannten Halbleiterspeichervorrichtung (14) als auch zu der Fehlerspeichereinrichtung (12) über eine Adressenwechseleinrichtung (11) umfaßt, welche zu der genannten Halbleiterspeichervorrichtung (14) und der genannten Fehlerspeichereinrichtung (12) zugreift, wobei die genannten Adressenmuster von dem genannten Adressenmustergenerator in einem normalen Betriebmodus geliefert werden, und welche zu der genannten Halbleiterspeichervorrichtung (14) und der genannten Fehlerspeichereinrichtung (12) mit einem von dem genannten Adressenmustergenerator (10) gelieferten Adressenmuster zugreift, in welchem in einem Swap-Modus

15 | **0 031 706** | 16

vorbestimmte Adressen ausgewechselt sind, und

(f) Sperren der genannten zweiten Phase des Betriebs der genannten Komparators (13) bei Empfang eine Adresse durch die genannte Fehlerspeichereinrichtung (12), bei welcher die entsprechende Speicherzelle der genannten Fehlerspeichereinrichtung (12) Information enthält, welche die Existenz eines Hardwarefehlers in der entsprechenden Speicherzelle der genannten Halbleiterspeichervorrichtung (14) anzeigt.

# FIG. 1

# FIG. 2A

# FIG. 2B

# FIG. 3A

14    ① ② ③ ④    → XX

① 
② 
YY ③ 
④         M2

# FIG. 3B

12    ① ② ③ ④    → XX

① 
② 
YY ③ 
④         F2

# FIG. 4

21

| MEM DEVICE |
| A0    A1    A2    A3    A4    A5 |

23 DRIV CARD

P1    P2    P3    P4    P5    P6
A0    A1    A2    A3    A4    A5

22 ADD SELECT

A0 : A6 : A1 : A7 : A2 : A8 : A3 : A9 : A4 : A10 : A5 : A11

24 ADD MPX

25 FAULT MEM

A0 A1 A2 A3 A4 A5 A6 A7 A8 A9 A10 A11

27 PIN SELECT

26 ADD SELECT

A0 A1 A2 A3 A4 A5 A6 A7 A8 A9 A10 A11

28

ADD PAT GEN

FIG. 5

0 031 706